# EUROPEAN PATENT APPLICATION

(11) **EP 4 521 899 A1**
(43) Date of publication of application: **12.03.2025**
(21) Application number: 24198667.8
(22) Date of filing: 05.09.2024
(51) Int. Cl.: H10K 59/122, H10K 59/80

(54) **DISPLAY DEVICE AND MANUFACTURING METHOD THEREOF**

(30) Priority: 11.09.2023 JP 2023147026
(71) Applicant: Japan Display Inc., Tokyo 105-0003 (JP)
(72) Inventor: FUKUDA, Kaichi, Tokyo, 105-0003 (JP)
(74) Representative: MERH-IP Matias Erny Reichl Hoffmann Patentanwälte PartG mbB

(57) **Abstract**

According to one embodiment, a display device (DSP) includes an insulating layer (12), a lower electrode (LE1, LE2, LE3), a rib layer (5) having a pixel aperture (AP1, AP2, AP3), a partition (6) including a lower portion (61) and an upper portion (62), an organic layer (OR1, OR2, OR3) which covers the lower electrode (LE1, LE2, LE3) through the pixel aperture (AP1, AP2, AP3), and an upper electrode (UE1, UE2, UE3) which covers the organic layer (OR1, OR2, OR3). Further, the lower electrode (LE1, LE2, LE3) includes a reflective layer (RL) which reflects light emitted from the organic layer (OR1, OR2, OR3), and a metal layer (ML) provided between the reflective layer (RL) and the insulating layer (12) and having an end portion which protrudes from the reflective layer (RL).

## Description

### FIELD

Embodiments described herein relate generally to a display device and a manufacturing method thereof.

### BACKGROUND

Recently, display devices to which an organic light emitting diode (OLED) is applied as a display element have been put into practical use. In this type of display devices, a technique which can improve the yield is required.

### BRIEF DESCRIPTION OF THE DRAWINGS

FIG. 1 is a diagram showing a configuration example of a display device according to a first embodiment.
FIG. 2 is a schematic plan view showing an example of the layout of subpixels according to the first embodiment.
FIG. 3 is a schematic cross-sectional view of the display device along the III-III line of FIG. 2.
FIG. 4 is a diagram showing an example of a layer structure which could be applied to each organic layer.
FIG. 5 is a schematic enlarged cross-sectional view of an organic insulating layer, a rib layer, a partition and lower electrodes according to the first embodiment.
FIG. 6 is a schematic cross-sectional view showing the manufacturing process of the display device according to the first embodiment.
FIG. 7 is a schematic cross-sectional view showing a process following FIG. 6.
FIG. 8 is a schematic cross-sectional view showing a process following FIG. 7.
FIG. 9 is a schematic cross-sectional view showing a process following FIG. 8.
FIG. 10 is a schematic cross-sectional view showing a process following FIG. 9.
FIG. 11 is a schematic cross-sectional view showing a process following FIG. 10.
FIG. 12 is a schematic cross-sectional view showing a process following FIG. 11.
FIG. 13 is a schematic cross-sectional view showing a process following FIG. 12.
FIG. 14 is a schematic cross-sectional view showing a process following FIG. 13.
FIG. 15 is a schematic cross-sectional view showing a process following FIG. 14.
FIG. 16 is a schematic cross-sectional view showing a process following FIG. 15.
FIG. 17 is a schematic cross-sectional view showing a process following FIG. 16.
FIG. 18 is a schematic cross-sectional view showing a process following FIG. 17.
FIG. 19 is a schematic cross-sectional view showing a process following FIG. 18.
FIG. 20 is a schematic cross-sectional view showing a process following FIG. 19.
FIG. 21 is a diagram for explaining an example of effects obtained from the first embodiment.
FIG. 22 is a schematic plan view showing an example of the layout of subpixels according to a second embodiment.
FIG. 23 is a schematic cross-sectional view of a display device along the XXIII-XXIII line of FIG. 22.
FIG. 24 is a schematic cross-sectional view of the configuration of a comparative example.
FIG. 25 is a schematic cross-sectional view of the configuration of another comparative example.

### DETAILED DESCRIPTION

In general, according to one embodiment, a display device comprises an insulating layer, a lower electrode provided above the insulating layer, a rib layer which has a pixel aperture overlapping the lower electrode, a partition which includes a lower portion provided above the rib layer and an upper portion having an end portion protruding from a side surface of the lower portion, an organic layer which covers the lower electrode through the pixel aperture and emits light based on application of voltage, and an upper electrode which covers the organic layer. Further, the lower electrode includes a reflective layer which reflects light emitted from the organic layer, and a metal layer provided between the reflective layer and the insulating layer and having an end portion which protrudes from the reflective layer.

According to another embodiment, a manufacturing method of a display device includes forming an insulating layer, forming, above the insulating layer, a lower electrode which includes a reflective layer reflecting light and a metal layer provided between the reflective layer and the insulating layer and having an end portion which protrudes from the reflective layer, forming a rib layer which covers the lower electrode, forming a partition which includes a lower portion provided above the rib layer and an upper portion having an end portion which protrudes from a side surface of the lower portion, forming a pixel aperture in the rib layer before forming the partition or after forming the partition, forming an organic layer which covers the lower electrode through the pixel aperture and emits light based on application of voltage, and forming an upper electrode which covers the organic layer.

Each embodiment can improve the yield of a display device.

Embodiments will be described with reference to the accompanying drawings.

The disclosure is merely an example, and proper changes in keeping with the spirit of the invention, which are easily conceivable by a person of ordinary skill in the art, come within the scope of the invention as a matter of course. In addition, in some cases, in order to make the description clearer, the widths, thicknesses, shapes, etc., of the respective parts are illustrated schematically in the drawings, rather than as an accurate representation of what is implemented. However, such schematic illustration is merely exemplary, and in no way restricts the interpretation of the invention. In addition, in the specification and drawings, structural elements which function in the same or a similar manner to those described in connection with preceding drawings are denoted by like reference numbers, detailed description thereof being omitted unless necessary.

In the drawings, in order to facilitate understanding, an X-axis, a Y-axis and a Z-axis orthogonal to each other are shown depending on the need. A direction parallel to the X-axis is referred to as an X-direction. A direction parallel to the Y-axis is referred to as a Y-direction. A direction parallel to the Z-axis is referred to as a Z-direction. The Z-direction is the normal direction of a plane including the X-direction and the Y-direction. When various elements are viewed parallel to the Z-direction, the appearance is defined as a plan view.

The display device of each embodiment is an organic electroluminescent display device comprising an organic light emitting diode (OLED) as a display element, and could be mounted on various types of electronic devices such as a television, a personal computer, a vehicle-mounted device, a tablet, a smartphone, a mobile phone and a wearable terminal.

### [First Embodiment]

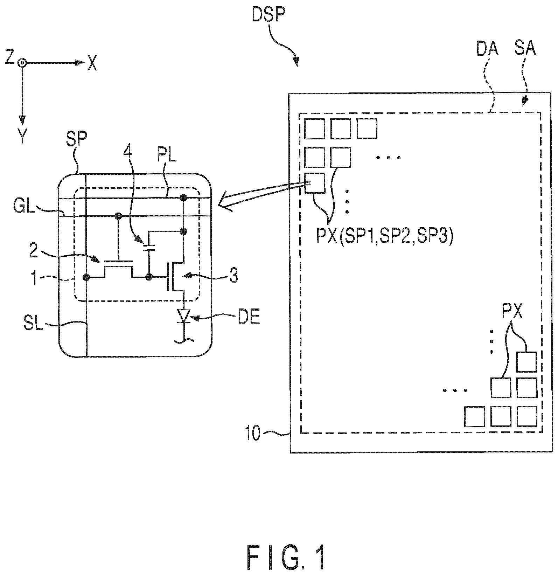

FIG. 1 is a diagram showing a configuration example of a display device DSP according to a first embodiment. The display device DSP comprises an insulating substrate 10. The substrate 10 has a display area DA which displays an image, and a surrounding area SA around the display area DA. The substrate 10 may be glass or a resinous film having flexibility.

In this embodiment, the substrate 10 is rectangular as seen in plan view. It should be noted that the shape of the substrate 10 in plan view is not limited to a rectangle and may be another shape such as a square, a circle or an oval.

The display area DA comprises a plurality of pixels PX arrayed in matrix in an X-direction and a Y-direction. Each pixel PX includes a plurality of subpixels SP which display different colors. This embodiment assumes a case where each pixel PX includes a blue subpixel SP1, a green subpixel SP2 and a red subpixel SP3. However, each pixel PX may include a subpixel SP which exhibits another color such as white in addition to subpixels SP1, SP2 and SP3 or instead of one of subpixels SP1, SP2 and SP3.

Each subpixel SP comprises a pixel circuit 1 and a display element DE driven by the pixel circuit 1. The pixel circuit 1 comprises a pixel switch 2, a drive transistor 3 and a capacitor 4. Each of the pixel switch 2 and the drive transistor 3 is, for example, a switching element consisting of a thin-film transistor.

A plurality of scanning lines GL which supply scanning signals to the pixel circuits 1 of subpixels SP, a plurality of signal lines SL which supply video signals to the pixel circuits 1 of subpixels SP and a plurality of power lines PL are provided in the display area DA. In the example of FIG. 1, the scanning lines GL and the power lines PL extend in the X-direction, and the signal lines SL extend in the Y-direction.

The gate electrode of the pixel switch 2 is connected to the scanning line GL. The source electrode of the pixel switch 2 is connected to the signal line SL. The drain electrode of the pixel switch 2 is connected to the gate electrode of the drive transistor 3 and the capacitor 4. The source electrode of the drive transistor 3 is connected to the power line PL and the capacitor 4. The drain electrode of the drive transistor 3 is connected to the display element DE.

It should be noted that the configuration of the pixel circuit 1 is not limited to the example shown in the figure. For example, the pixel circuit 1 may comprise more thin-film transistors and capacitors.

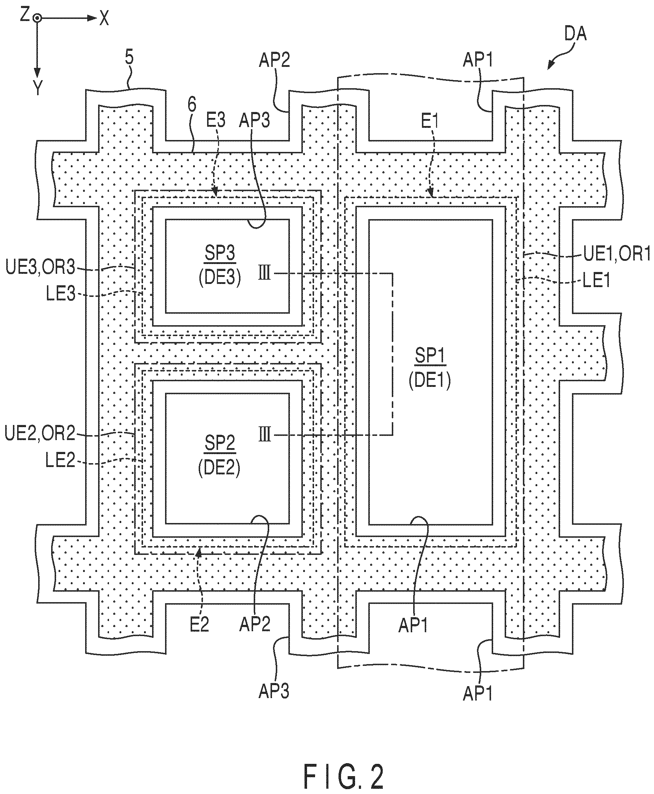

FIG. 2 is a schematic plan view showing an example of the layout of subpixels SP1, SP2 and SP3. In the example of FIG. 2, each of subpixels SP2 and SP3 is adjacent to subpixel SP1 in the X-direction. Further, subpixels SP2 and SP3 are arranged in the Y-direction.

When subpixels SP1, SP2 and SP3 are provided in line with this layout, a column in which subpixels SP2 and SP3 are alternately provided in the Y-direction and a column in which a plurality of subpixels SP1 are repeatedly provided in the Y-direction are formed in the display area DA. These columns are alternately arranged in the X-direction. It should be noted that the layout of subpixels SP1, SP2 and SP3 is not limited to the example of FIG. 2.

A rib layer 5 is provided in the display area DA. The rib layer 5 has pixel apertures AP1, AP2 and AP3 in subpixels SP1, SP2 and SP3, respectively. In the example of FIG. 2, the pixel aperture AP1 is larger than the pixel aperture AP2. The pixel aperture AP2 is larger than the pixel aperture AP3. Thus, among subpixels SP1, SP2 and SP3, the aperture ratio of subpixel SP1 is the greatest, and the aperture ratio of subpixel SP3 is the least. It should be noted that the size of the pixel aperture AP1, AP2 or AP3 is not limited to this example. For example, at least two of the pixel apertures AP1, AP2 and AP3 may have the same size.

Subpixel SP1 comprises a lower electrode LE1, an upper electrode UE1 and an organic layer OR1 overlapping the pixel aperture AP1. Subpixel SP2 comprises a lower electrode LE2, an upper electrode UE2 and an organic layer OR2 overlapping the pixel aperture AP2. Subpixel SP3 comprises a lower electrode LE3, an upper electrode UE3 and an organic layer OR3 overlapping the pixel aperture AP3.

Of the lower electrode LE1, the upper electrode UE1 and the organic layer OR1, the portions which overlap the pixel aperture AP1 constitute the display element DE1 of subpixel SP1. Of the lower electrode LE2, the upper electrode UE2 and the organic layer OR2, the portions which overlap the pixel aperture AP2 constitute the display element DE2 of subpixel SP2. Of the lower electrode LE3, the upper electrode UE3 and the organic layer OR3, the portions which overlap the pixel aperture AP3 constitute the display element DE3 of subpixel SP3. Each of the display elements DE1, DE2 and DE3 may further include a cap layer as described later. The rib layer 5 surrounds each of these display elements DE1, DE2 and DE3.

A partition 6 is provided in the display area DA. The partition 6 is located above the rib layer 5 and overlaps the rib layer 5 as a whole. In the example of FIG. 2, the partition 6 has a planar shape similar to that of the rib layer 5. In other words, the partition 6 comprises an aperture in each of subpixels SP1, SP2 and SP3. From another viewpoint, each of the rib layer 5 and the partition 6 has a grating shape as seen in plan view, and surrounds each of the display elements DE1, DE2 and DE3. The partition 6 functions as lines which apply common voltage to the upper electrodes UE1, UE2 and UE3.

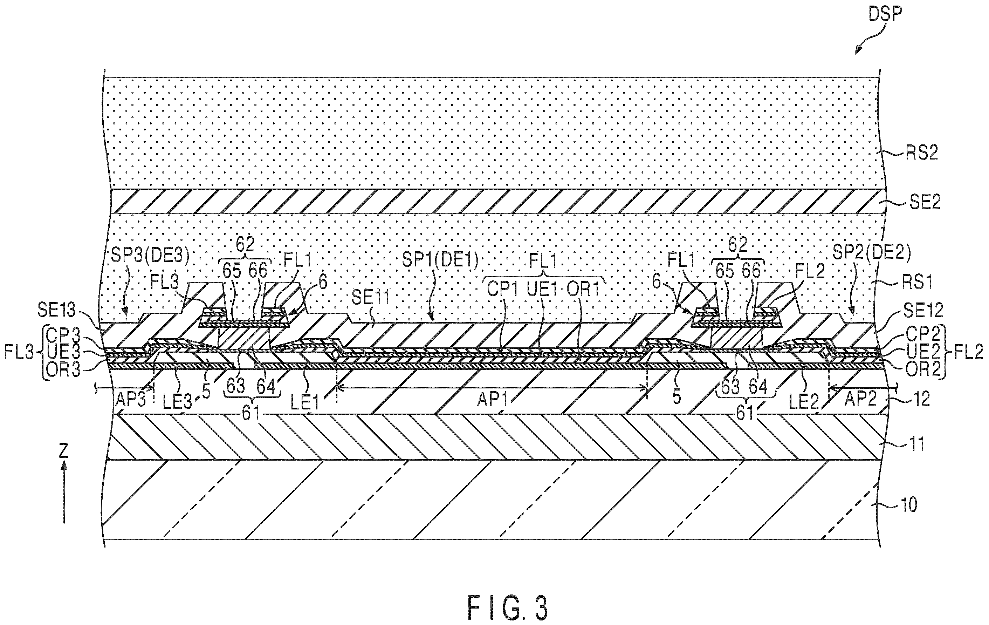

FIG. 3 is a schematic cross-sectional view of the display device DSP along the III-III line of FIG. 2. A circuit layer 11 is provided on the substrate 10 described above. The circuit layer 11 includes various circuits and lines such as the pixel circuits 1, scanning lines GL, signal lines SL and power lines PL shown in FIG. 1. The circuit layer 11 is covered with an organic insulating layer 12. The organic insulating layer 12 functions as a planarization film which planarizes the irregularities formed by the circuit layer 11.

The lower electrodes LE1, LE2 and LE3 are provided on the organic insulating layer 12. The rib layer 5 is provided on the organic insulating layer 12 and the lower electrodes LE1, LE2 and LE3. The end portions of the lower electrodes LE1, LE2 and LE3 are covered with the rib layer 5. Although not shown in the section of FIG. 3, the lower electrodes LE1, LE2 and LE3 are connected to the respective pixel circuits 1 (the drain electrodes of the drive transistors 3 shown in FIG. 1) of the circuit layer 11 through respective contact holes provided in the organic insulating layer 12.

The partition 6 includes a conductive lower portion 61 provided on the rib layer 5 and an upper portion 62 provided on the lower portion 61. The upper portion 62 has a width greater than that of the lower portion 61. By this configuration, the both end portions of the upper portion 62 protrude relative to the side surfaces of the lower portion 61. This shape of the partition 6 is called an overhang shape.

In the example of FIG. 3, the lower portion 61 has a bottom layer 63 and a stem layer 64. The bottom layer 63 is located between the stem layer 64 and the rib layer 5. Further, in the example of FIG. 3, the upper portion 62 has a first top layer 65 and a second top layer 66. The first top layer 65 is provided on the stem layer 64. The second top layer 66 is provided on the first top layer 65.

The organic layer OR1 covers the lower electrode LE1 through the pixel aperture AP1. The upper electrode UE1 covers the organic layer OR1 and faces the lower electrode LE1. The organic layer OR2 covers the lower electrode LE2 through the pixel aperture AP2. The upper electrode UE2 covers the organic layer OR2 and faces the lower electrode LE2. The organic layer OR3 covers the lower electrode LE3 through the pixel aperture AP3. The upper electrode UE3 covers the organic layer OR3 and faces the lower electrode LE3. The upper electrodes UE1, UE2 and UE3 are in contact with the side surfaces of the lower portions 61 of the partitions 6.

The display element DE1 includes a cap layer CP1 which covers the upper electrode UE1. The display element DE2 includes a cap layer CP2 which covers the upper electrode UE2. The display element DE3 includes a cap layer CP3 which covers the upper electrode UE3. The cap layers CP1, CP2 and CP3 function as optical adjustment layers which improve the extraction efficiency of the light emitted from the organic layers OR1, OR2 and OR3, respectively.

In the following explanation, a multilayer body including the organic layer OR1, the upper electrode UE1 and the cap layer CP1 is called a stacked film FL1. A multilayer body including the organic layer OR2, the upper electrode UE2 and the cap layer CP2 is called a stacked film FL2. A multilayer body including the organic layer OR3, the upper electrode UE3 and the cap layer CP3 is called a stacked film FL3.

The stacked film FL1 is partly located on the upper portion 62. This portion is spaced apart from, of the stacked film FL1, the portion located around the partition 6 (in other words, the portion which constitutes the display element DE1). Similarly, the stacked film FL2 is partly located on the upper portion 62. This portion is spaced apart from, of the stacked film FL2, the portion located around the partition 6 (in other words, the portion which constitutes the display element DE2). Further, the stacked film FL3 is partly located on the upper portion 62. This portion is spaced apart from, of the stacked film FL3, the portion located around the partition 6 (in other words, the portion which constitutes the display element DE3).

Sealing layers SE11, SE12 and SE13 which cover the stacked films FL1, FL2 and FL3, respectively, are provided in subpixels SP1, SP2 and SP3, respectively. Specifically, the sealing layer SE11 continuously covers the cap layer CP1 and the partition 6 around subpixel SP1. The sealing layer SE12 continuously covers the cap layer CP2 and the partition 6 around subpixel SP2. The sealing layer SE13 continuously covers the cap layer CP3 and the partition 6 around subpixel SP3.

In the example of FIG. 3, the stacked film FL1 and sealing layer SE11 located on the partition 6 between subpixels SP1 and SP2 are spaced apart from the stacked film FL2 and sealing layer SE12 located on this partition 6. The stacked film FL1 and sealing layer SE11 located on the partition 6 between subpixels SP1 and SP3 are spaced apart from the stacked film FL3 and sealing layer SE13 located on this partition 6.

The sealing layers SE11, SE12 and SE13 are covered with a resin layer RS1. The resin layer RS1 is covered with a sealing layer SE2. The sealing layer SE2 is covered with a resin layer RS2. The resin layers RS1 and RS2 and the sealing layer SE2 are continuously provided in at least the entire display area DA and partly extend in the surrounding area SA as well.

A cover member such as a polarizer, a protective film or a cover glass may be further provided above the resin layer RS2. This cover member may be attached to the resin layer RS2 via, for example, an adhesive layer such as an optical clear adhesive (OCA).

The organic insulating layer 12 is formed of an organic insulating material such as polyimide. Each of the rib layer 5, the sealing layers SE11, SE12, SE13 and SE2 is formed of, for example, an inorganic insulating material such as silicon nitride (SiNx), silicon oxide (SiOx) or silicon oxynitride (SiON). For example, the rib layer 5 is formed of silicon oxynitride, and each of the sealing layers SE11, SE12, SE13 and SE2 is formed of silicon nitride. Each of the resin layers RS1 and RS2 is formed of, for example, a resinous material (organic insulating material) such as epoxy resin or acrylic resin.

Each of the upper electrodes UE1, UE2 and UE3 is formed of, for example, a metal material such as an alloy of magnesium and silver (MgAg). For example, the lower electrodes LE1, LE2 and LE3 correspond to anodes, and the upper electrodes UE1, UE2 and UE3 correspond to cathodes.

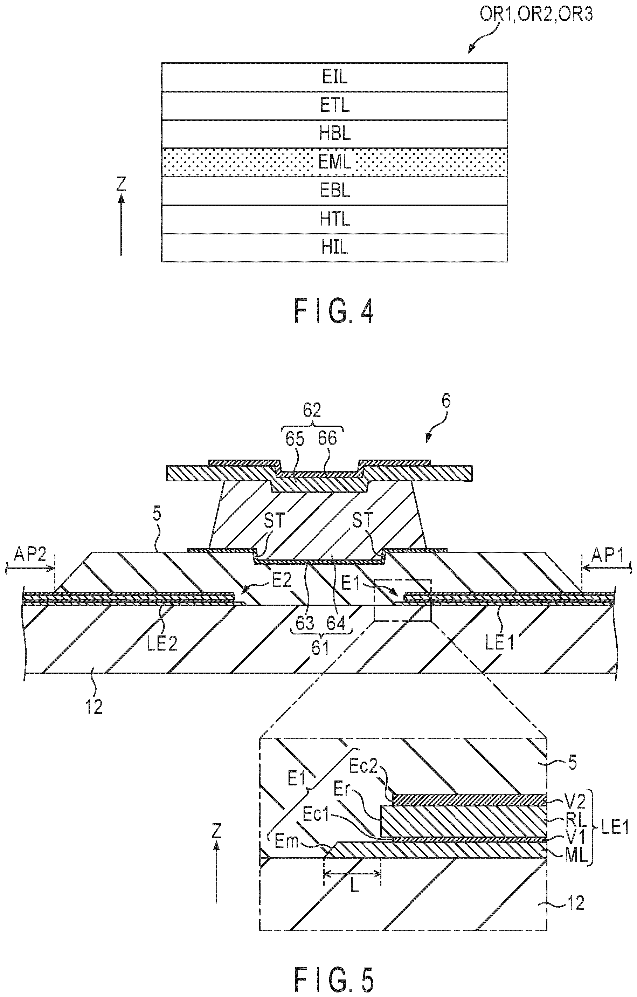

FIG. 4 is a diagram showing an example of a layer structure which could be applied to the organic layers OR1, OR2 and OR3. Each of the organic layers OR1, OR2 and OR3 consists of a plurality of thin films including a light emitting layer EML. This embodiment assumes a case where each of the organic layers OR1, OR2 and OR3 comprises a structure in which a hole injection layer HIL, a hole transport layer HTL, an electron blocking layer EBL, a light emitting layer EML, a hole blocking layer HBL, an electron transport layer ETL and an electron injection layer EIL are stacked in order in a Z-direction. It should be noted that each of the organic layers OR1, OR2 and OR3 may comprise another structure such as a tandem structure including a plurality of light emitting layers EML.

Each of the cap layers CP1, CP2 and CP3 comprises, for example, a multilayer structure in which a plurality of transparent layers are stacked. These transparent layers could include a layer formed of an inorganic material and a layer formed of an organic material. The transparent layers have refractive indices different from each other. For example, the refractive indices of these transparent layers are different from the refractive indices of the upper electrodes UE1, UE2 and UE3 and the refractive indices of the sealing layers SE11, SE12 and SE13. It should be noted that at least one of the cap layers CP1, CP2 and CP3 may be omitted.

Common voltage is applied to the partition 6. This common voltage is applied to each of the upper electrodes UE1, UE2 and UE3 which are in contact with the lower portions 61. Pixel voltage is applied to the lower electrodes LE1, LE2 and LE3 through the pixel circuits 1 provided in subpixels SP1, SP2 and SP3, respectively, based on the video signals of the signal lines SL.

The organic layers OR1, OR2 and OR3 emit light based on the application of voltage. Specifically, when a potential difference is formed between the lower electrode LE1 and the upper electrode UE1, the light emitting layer EML of the organic layer OR1 emits light in a blue wavelength range. When a potential difference is formed between the lower electrode LE2 and the upper electrode UE2, the light emitting layer EML of the organic layer OR2 emits light in a green wavelength range. When a potential difference is formed between the lower electrode LE3 and the upper electrode UE3, the light emitting layer EML of the organic layer OR3 emits light in a red wavelength range.

As another example, the light emitting layers EML of the organic layers OR1, OR2 and OR3 may emit light exhibiting the same color (for example, white). In this case, the display device DSP may comprise color filters which convert the light emitted from the light emitting layers EML into light exhibiting colors corresponding to subpixels SP1, SP2 and SP3. The display device DSP may comprise a layer including quantum dots which generate light exhibiting colors corresponding to subpixels SP1, SP2 and SP3 by the excitation caused by the light emitted from the light emitting layers EML.

FIG. 5 is a schematic enlarged cross-sectional view of the organic insulating layer 12, the rib layer 5, the partition 6 and the lower electrodes LE1 and LE2. In the example of FIG. 5, the bottom layer 63 protrudes from the side surfaces of the stem layer 64. The width of the second top layer 66 is less than that of the first top layer 65. By this configuration, the upper surface of the first top layer 65 near the both end portions is exposed from the second top layer 66. The stem layer 64 is formed so as to be thicker than the bottom layer 63, the first top layer 65 and the second top layer 66.

Each of the bottom layer 63 and the stem layer 64 is formed of, for example, a metal material. For the metal material of the bottom layer 63, for example, molybdenum (Mo), titanium (Ti), titanium nitride (TiN), a molybdenum-tungsten alloy (MoW) or a molybdenum-niobium alloy (MoNb) can be used. For the metal material of the stem layer 64, for example, aluminum (Al), an aluminum-neodymium alloy (AlNd), an aluminum-yttrium alloy (AlY) or an aluminum-silicon alloy (AlSi) can be used. It should be noted that at least one of the bottom layer 63 and the stem layer 64 may comprise a multilayer structure consisting of a plurality of layers. The stem layer 64 may include a layer formed of an insulating material. Further, the lower portion 61 may comprise a single-layer structure formed of a conductive material.

For example, the first top layer 65 is formed of a metal material, and the second top layer 66 is formed of a transparent conductive oxide. For the metal material of the first top layer 65, for example, titanium, titanium nitride, molybdenum, tungsten, a molybdenum-tungsten alloy or a molybdenum-niobium alloy can be used. For the conductive oxide of the second top layer 66, for example, indium tin oxide (ITO), indium zinc oxide (IZO) or indium gallium zinc oxide (IGZO) can be used. It should be noted that the upper portion 62 may comprise a single-layer structure formed of a specific material. The upper portion 62 may further include a layer formed of an insulating material.

The lower electrode LE1 has an end portion E1. In this embodiment, as shown in FIG. 2, the end portion E1 overlaps the partition 6 (lower portion 61) over the whole circumference of the lower electrode LE1 as seen in plan view. More specifically, the end portion E1 is located under the stem layer 64 as shown in FIG. 5. Similarly, an end portion E2 of the lower electrode LE2 and an end portion E3 of the lower electrode LE3 are located under the stem layer 64 over the whole circumferences of the lower electrodes LE2 and LE3, respectively. It should be noted that each of the end portions E1, E2 and E3 may have a portion which does not overlap the stem layer 64 in plan view.

As shown in FIG. 5, stepped portions ST are generated on the upper surface of the rib layer 5 due to the end portions E1 and E2 of the lower electrodes LE1 and LE2. Although not shown in the section of FIG. 5, further, a stepped portion ST is generated on the upper surface of the rib layer 5 due to the end portion E3 of the lower electrode LE3. In this embodiment, these stepped portions ST are covered with the bottom layer 63 and the stem layer 64. The upper surface of each of the stem layer 64, the first top layer 65 and the second top layer 66 may be deformed based on the stepped portions ST.

As shown in the enlarged view of FIG. 5, the lower electrode LE1 includes a reflective layer RL and a metal layer ML. The reflective layer RL reflects the light emitted from the organic layer OR1 in the Z-direction. The metal layer ML is provided between the reflective layer RL and the organic insulating layer 12.

The lower electrode LE1 further includes a first coating layer V1 and a second coating layer V2. The first coating layer V1 covers the lower surface of the reflective layer RL facing the metal layer ML. The second coating layer V2 covers the upper surface of the reflective layer RL. The first coating layer V1 improves the adherence between the reflective layer RL and the metal layer ML. The second coating layer V2 protects the reflective layer RL from various types of etching at the time of manufacturing the display device DSP.

The reflective layer RL can be formed of, for example, a metal material excellent in light reflectivity, such as silver. Each of the coating layers V1 and V2 can be formed of, for example, a transparent conductive oxide such as ITO, IZO or IGZO. The metal layer ML can be formed of, for example, titanium, titanium nitride, tungsten or a molybdenum-tungsten alloy.

In the example of FIG. 5, all of the metal layer ML, the first coating layer V1 and the second coating layer V2 are thinner than the reflective layer RL. The first coating layer V1 is thinner than the metal layer ML and the second coating layer V2. It should be noted that the relationships of the thicknesses of the reflective layer RL, the metal layer ML, the first coating layer V1 and the second coating layer V2 are not limited to the example shown here.

For example, the thickness of the reflective layer RL is 40 to 150 nm. The thickness of the metal layer ML is 10 to 50 nm. The thickness of the first coating layer V1 is 5 to 10 nm. The thickness of the second coating layer V2 is 5 to 50 nm.

The end portion E1 of the lower electrode LE1 includes an end portion Em of the metal layer ML, an end portion Er of the reflective layer RL, an end portion Ec1 of the first coating layer V1 and an end portion Ec2 of the second coating layer V2.

In this embodiment, the end portion Em protrudes from the end portion Er. The end portions Ec1 and Ec2 are retracted relative to the end portion Er. The protrusion length L of the metal layer ML from the reflective layer RL is, for example, greater than or equal to the thickness of the reflective layer RL.

In the example of FIG. 5, the end portion Em has a tapered shape in which the thickness gradually decreases. This inclined surface of the end portion Em makes an angle of, for example, 60° or less with respect to the upper surface of the organic insulating layer 12.

Now, this specification explains an example of the manufacturing method of the display device DSP according to the embodiment.

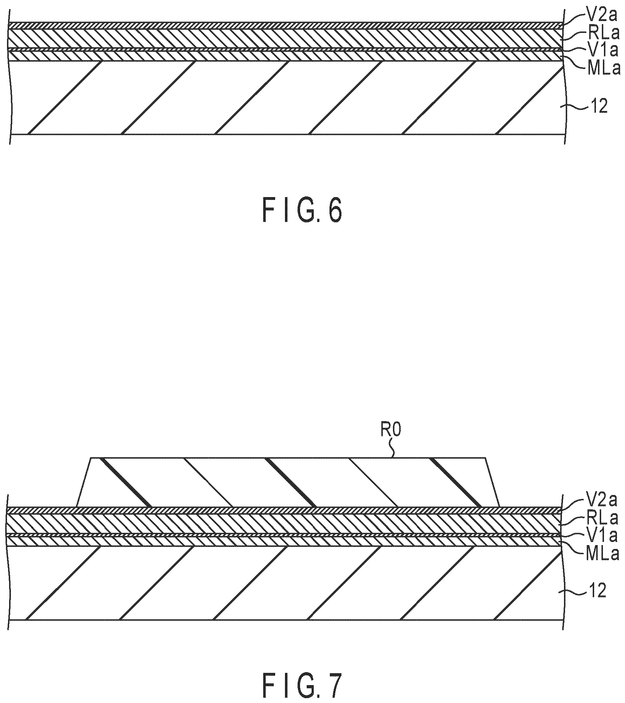

FIG. 6 to FIG. 20 are schematic cross-sectional views showing the manufacturing process of the display device DSP. In these figures, the illustrations of the substrate 10 and the circuit layer 11 are omitted.

To manufacture the display device DSP, first, the circuit layer 11 and the organic insulating layer 12 are formed on the substrate 10. Subsequently, as shown in FIG. 6, a metal layer (first layer) MLa formed of a metal material, a first coating layer V1a formed of a transparent conductive oxide, a reflective layer (second layer) RLa formed of a metal material and a second coating layer V2a formed of a transparent conductive oxide are formed in order on the organic insulating layer 12.

The metal layer MLa, the first coating layer V1a, the reflective layer RLa and the second coating layer V2a are the layers to be processed into the metal layer ML, first coating layer V1, reflective layer RL and second coating layer V2 described above, respectively. All of these layers are formed in the entire part of the display area DA and the surrounding area SA by, for example, sputtering.

The thicknesses of the metal layer MLa, the first coating layer V1a, the reflective layer RLa and the second coating layer V2a may be determined in the ranges of the values described above as the thicknesses of the metal layer ML, the first coating layer V1, the reflective layer RL and the second coating layer V2. Specifically, for example, the thickness of the metal layer MLa is 30 nm. The thickness of the reflective layer RLa is 100 nm. The thickness of the first coating layer V1a is 10 nm. The thickness of the second coating layer V2a is 25 nm.

Subsequently, a resist R0 having a shape corresponding to the lower electrodes LE1, LE2 and LE3 is provided on the second coating layer V2a as shown in FIG. 7. It should be noted that FIG. 7 to FIG. 12 show how the lower electrode LE1 is formed. The lower electrodes LE2 and LE3 are formed at the same time as the lower electrode LE1.

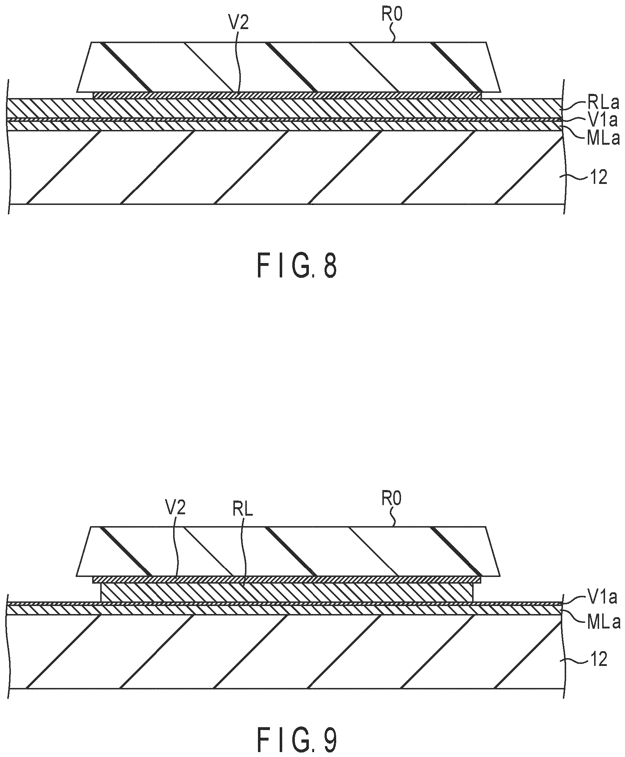

After the formation of the resist R0, wet etching for the second coating layer V2a is performed. In this wet etching, the portion of the second coating layer V2a exposed from the resist R0 is removed. By this process, as shown in FIG. 8, the second coating layer V2 is formed. In the example of FIG. 8, the second coating layer V2 having a width which is slightly less than that of the resist R0 is formed.

Subsequently, wet etching (first etching) for the reflective layer RLa is performed. In this wet etching, the portion of the reflective layer RLa exposed from the resist R0 is removed. By this process, as shown in FIG. 9, the reflective layer RL is formed. Further, in this wet etching, the width of the reflective layer RL is slightly reduced relative to the width of the resist R0. By this process, in the example of FIG. 9, the reflective layer RL having a width which is slightly less than that of the second coating layer V2 is formed.

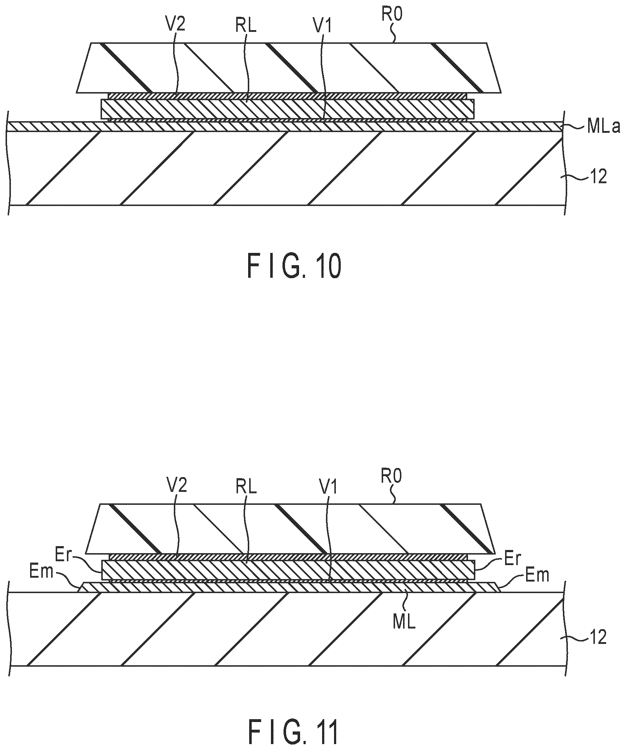

After the formation of the reflective layer RL, wet etching for the first coating layer V1a is performed. In this wet etching, the portion of the first coating layer V1a exposed from the resist R0 is removed. By this process, as shown in FIG. 10, the first coating layer V1 is formed. In the example of FIG. 10, the first coating layer V1 having a width which is slightly less than that of the reflective layer RL is formed. In this wet etching, the second coating layer V2 could be also corroded. By this process, in the example of FIG. 10, the width of the second coating layer V2 is slightly reduced relative to the reflective layer RL.

It is preferable that the material of the metal layer MLa should not be easily corroded by the etchant used in the wet etching of the reflective layer RLa or the coating layer V1a or V2a. For example, in the wet etching of the reflective layer RLa, an etchant containing phosphoric acid, nitric acid and acetic acid is used. The metal layer MLa is formed of, for example, a metal material in which the etching rate for this etchant is slower than the reflective layer RLa.

After the formation of the first coating layer V1, dry etching (second etching) for the metal layer MLa is performed. In this dry etching, the portion of the metal layer MLa exposed from the resist R0 is removed. By this process, as shown in FIG. 11, the metal layer ML is formed.

The anisotropy of this dry etching is higher than that of each of the above wet etching processes. Therefore, the metal layer ML is patterned into a planar shape which is close to the resist R0 compared to the reflective layer RL, the first coating layer V1 and the second coating layer V2. As a result, as shown in FIG. 11, the end portion Em of the metal layer ML protrudes from the end portion Er of the reflective layer RL.

In this dry etching, the resist R0 is also slightly corroded. As a result, the width of the resist R0 is gradually reduced during dry etching. By this process, the end portion Em of the metal layer ML is tapered.

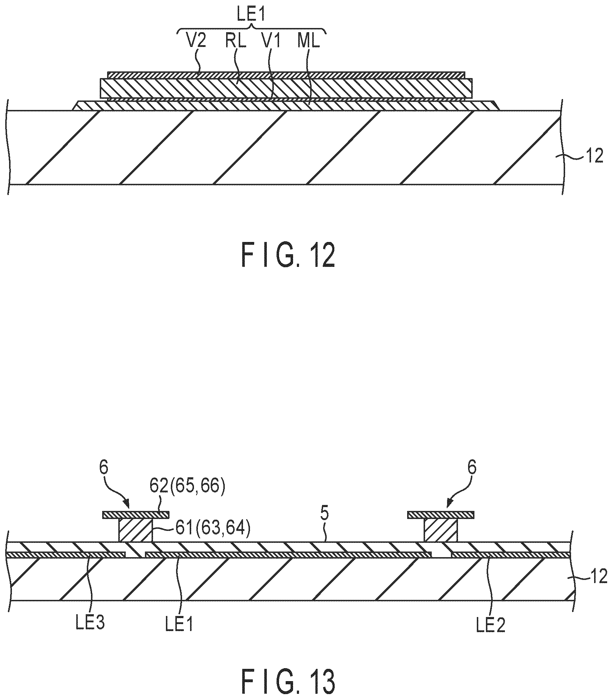

After the metal layer ML, the first coating layer V1, the reflective layer RL and the second coating layer V2 are formed in this manner, the resist R0 is removed. Thus, the lower electrode LE1 is completed as shown in FIG. 12. Similarly, the lower electrodes LE2 and LE3 are completed.

After the formation of the lower electrodes LE1, LE2 and LE3, as shown in FIG. 13, the rib layer 5 which covers the lower electrodes LE1, LE2 and LE3 is formed. Further, the partition 6 having the lower portion 61 and the upper portion 62 is formed on the rib layer 5. The lower portion 61 includes the bottom layer 63 and the stem layer 64 as shown in FIG. 5. The upper portion 62 includes the first top layer 65 and the second top layer 66 as shown in FIG. 5. It should be noted that the structures of the lower electrodes LE1, LE2 and LE3 are simplified in FIG. 13.

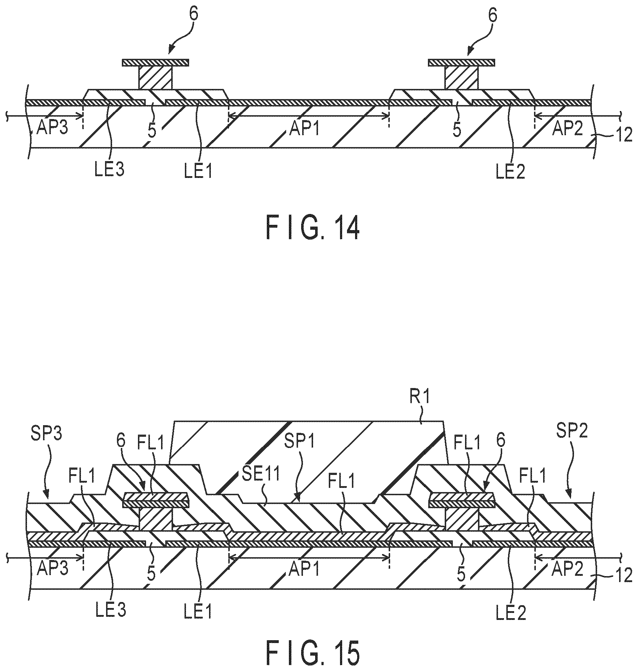

After the formation of the partition 6, as shown in FIG. 14, the pixel apertures AP1, AP2 and AP3 are formed in the rib layer 5. As another example, the pixel apertures AP1, AP2 and AP3 may be formed before the formation of the partition 6.

Subsequently, a process for forming the display elements DE1, DE2 and DE3 is performed. In this embodiment, this specification assumes a case where the display element DE1 is formed firstly, and the display element DE2 is formed secondly, and the display element DE3 is formed lastly. It should be noted that the formation order of the display elements DE1, DE2 and DE3 is not limited to this example.

To form the display element DE1, first, as shown in FIG. 15, the stacked film FL1 and the sealing layer SE11 are formed. The stacked film FL1 includes, as shown in FIG. 3, the organic layer OR1 which is in contact with the lower electrode LE1 through the pixel aperture AP1, the upper electrode UE1 which covers the organic layer OR1 and the cap layer CP1 which covers the upper electrode UE1.

The organic layer OR1, the upper electrode UE1 and the cap layer CP1 are formed by vapor deposition. The sealing layer SE11 is formed by chemical vapor deposition (CVD). The stacked film FL1 is divided into a plurality of portions by the partition 6 having an overhang shape. The sealing layer SE11 continuously covers the portions into which the stacked film FL1 is divided, and the partition 6.

After the formation of the stacked film FL1 and the sealing layer SE11, as shown in FIG. 15, a resist R1 is provided on the sealing layer SE11. The resist R1 covers subpixel SP1 and part of the partition 6 around the subpixel.

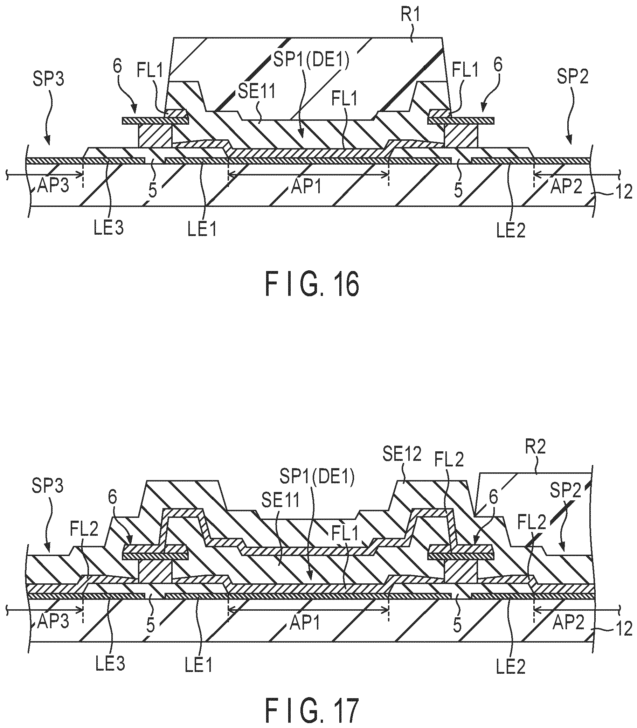

Subsequently, as shown in FIG. 16, the portions of the stacked film FL1 and the sealing layer SE11 exposed from the resist R1 are removed by etching using the resist R1 as a mask. By this process, the display element DE1 is formed in subpixel SP1. For example, this etching includes wet etching and dry etching processes which are performed in order for the sealing layer SE11, the cap layer CP1, the upper electrode UE1 and the organic layer OR1. After these etching processes, the resist R1 is removed.

The display element DE2 is formed by a procedure similar to that of the display element DE1. Specifically, when the display element DE2 is formed, as shown in FIG. 17, the stacked film FL2 and the sealing layer SE12 are formed in the entire display area DA. The stacked film FL2 includes, as shown in FIG. 3, the organic layer OR2 which is in contact with the lower electrode LE2 through the pixel aperture AP2, the upper electrode UE2 which covers the organic layer OR2 and the cap layer CP2 which covers the upper electrode UE2.

The organic layer OR2, the upper electrode UE2 and the cap layer CP2 are formed by vapor deposition. The sealing layer SE12 is formed by CVD. The stacked film FL2 is divided into a plurality of portions by the partition 6 having an overhang shape. The sealing layer SE12 continuously covers the portions into which the stacked film FL2 is divided, and the partition 6.

After the formation of the stacked film FL2 and the sealing layer SE12, as shown in FIG. 17, a resist R2 is provided on the sealing layer SE12. The resist R2 covers subpixel SP2 and part of the partition 6 around the subpixel.

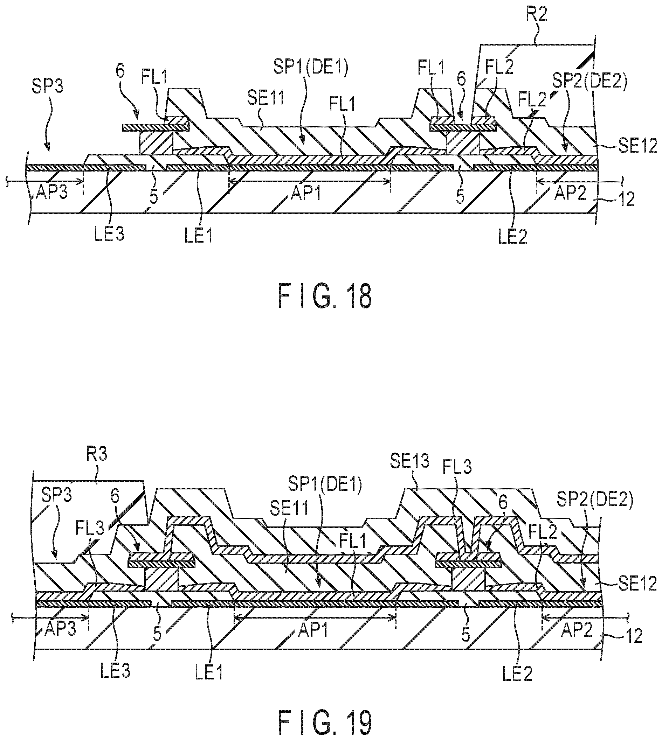

Subsequently, as shown in FIG. 18, the portions of the stacked film FL2 and the sealing layer SE12 exposed from the resist R2 are removed by etching using the resist R2 as a mask. By this process, the display element DE2 is formed in subpixel SP2. For example, this etching includes wet etching and dry etching processes which are performed in order for the sealing layer SE12, the cap layer CP2, the upper electrode UE2 and the organic layer OR2. After these etching processes, the resist R2 is removed.

The display element DE3 is formed by a procedure similar to the procedures of the display elements DE1 and DE2. Specifically, when the display element DE3 is formed, as shown in FIG. 19, the stacked film FL3 and the sealing layer SE13 are formed in the entire display area DA. The stacked film FL3 includes, as shown in FIG. 3, the organic layer OR3 which is in contact with the lower electrode LE3 through the pixel aperture AP3, the upper electrode UE3 which covers the organic layer OR3 and the cap layer CP3 which covers the upper electrode UE3.

The organic layer OR3, the upper electrode UE3 and the cap layer CP3 are formed by vapor deposition. The sealing layer SE13 is formed by CVD. The stacked film FL3 is divided into a plurality of portions by the partition 6 having an overhang shape. The sealing layer SE13 continuously covers the portions into which the stacked film FL3 is divided, and the partition 6.

After the formation of the stacked film FL3 and the sealing layer SE13, as shown in FIG. 19, a resist R3 is provided on the sealing layer SE13. The resist R3 covers subpixel SP3 and part of the partition 6 around the subpixel.

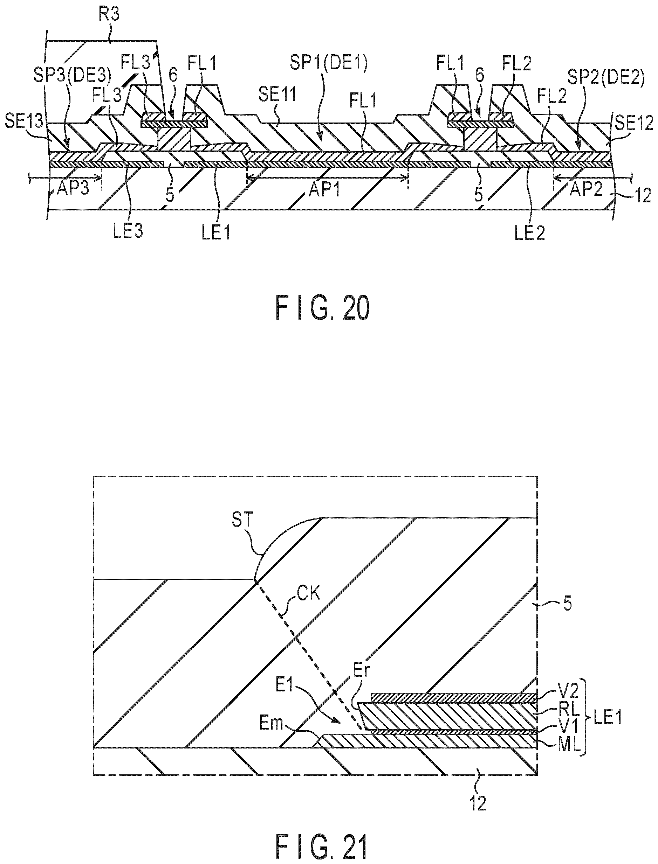

Subsequently, as shown in FIG. 20, the portions of the stacked film FL3 and the sealing layer SE13 exposed from the resist R3 are removed by etching using the resist R3 as a mask. By this process, the display element DE3 is formed in subpixel SP3. For example, this etching includes wet etching and dry etching processes which are performed in order for the sealing layer SE13, the cap layer CP3, the upper electrode UE3 and the organic layer OR3. After these etching processes, the resist R3 is removed.

After the display elements DE1, DE2 and DE3 are formed, the resin layer RS1, sealing layer SE2 and resin layer RS2 shown in FIG. 3 are formed in order. The display device DSP is completed through this process.

In the embodiment explained above, the partition 6 having an overhang shape allows the acquisition of the display device DSP comprising the display elements DE1, DE2 and DE3 which are separated from each other for the respective subpixels SP1, SP2 and SP3 and are individually sealed.

In addition, the configuration of the lower electrodes LE1, LE2 and LE3 of the embodiment can improve the yield and reliability of the display device DSP. These effects are explained below.

FIG. 21 is a diagram for explaining an example of effects obtained from this embodiment and shows the structure of the vicinity of the end portion E1 of the lower electrode LE1. To increase the reflectance of the lower electrode LE1, the reflective layer RL should be formed so as to be thick. It is difficult to form the end portion Er of the reflective layer RL formed of a metal material such as silver and processed by wet etching so as to have a tapered shape such as the end portion Em of the metal layer ML. Thus, the end portion Er could be formed into a sheer shape substantially parallel to the Z-direction as shown in FIG. 5 or formed into an overhang shape in which the upper end protrudes as shown in FIG. 21.

Further, in this embodiment, the rib layer 5 is formed of an inorganic insulating material. In this case, a crack CK which extends from the end portion Er to the stepped portion ST of the upper surface of the rib layer 5 may be generated. If the lower electrode LE1 does not comprise the metal layer ML, a moisture path from the organic insulating layer 12 to the upper surface of the rib layer 5 through the crack CK could be formed. If the moisture of the organic insulating layer 12 reaches the upper surface of the rib layer 5 through the moisture path, there is a possibility that, for example, the organic layer OR1 provided on the rib layer 5 is corroded, thereby causing a display failure.

To the contrary, in this embodiment, the metal layer ML having the end portion Em protruding from the reflective layer RL is provided. By this configuration, even when the crack CK is formed, the moisture path connecting the crack CK to the organic insulating layer 12 can be blocked by the metal layer ML.

In addition, in this embodiment, the metal layer ML is formed so as to be thinner than the reflective layer RL. Further, the end portion Em of the metal layer ML has a tapered shape. These configurations prevent the generation of a crack CK caused by the end portion Em.

In the embodiment, the stepped portion ST of the upper surface of the rib layer 5 generated by the lower electrode LE1 is covered with the lower portion 61. In this case, the lower portion 61 can also block the moisture path caused by the crack CK.

Here, the effects obtained from the embodiment are explained by particularly looking at the lower electrode LE1. However, effects similar to those of the lower electrode LE1 are obtained regarding the lower electrodes LE2 and LE3 since the lower electrodes LE2 and LE3 comprise configurations similar to the configuration of the lower electrode LE1.

### [Second Embodiment]

A second embodiment is explained. The configurations which are not particularly referred to in this embodiment are the same as those of the first embodiment.

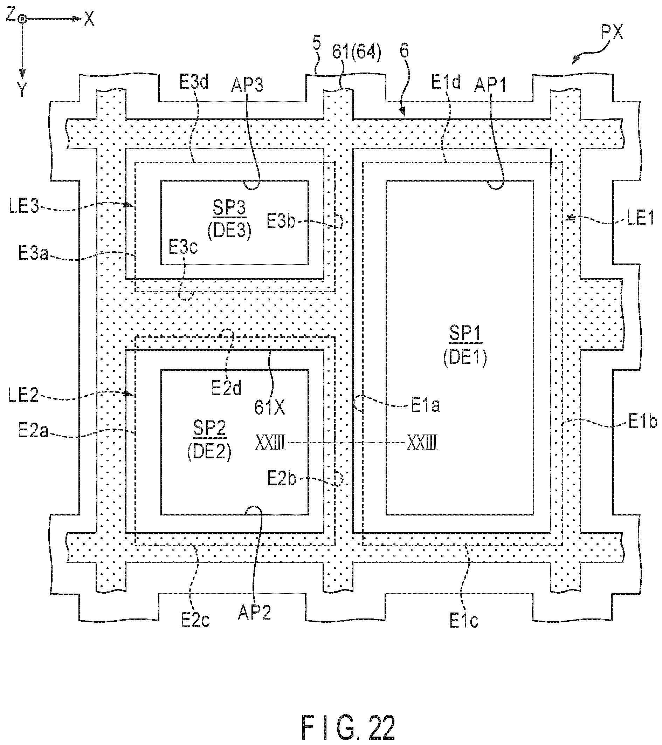

FIG. 22 is a schematic plan view showing an example of the layout of subpixels SP1, SP2 and SP3 according to this embodiment. As shown in FIG. 22, a lower electrode LE1 has end portions E1a, E1b, E1c and E1d. A lower electrode LE2 has end portions E2a, E2b, E2c and E2d. A lower electrode LE3 has end portions E3a, E3b, E3c and E3d. The end portions E1a, E1b, E2a, E2b, E3a and E3b extend parallel to a Y-direction. The end portions E1c, E1d, E2c, E2d, E3c and E3d extend parallel to an X-direction. All of the end portions are covered with a rib layer 5.

The partition 6 shown in FIG. 22 corresponds to the shape of a lower portion 61, more specifically, the shape of a stem layer 64. In this embodiment, a part (first end portion) of the end portion of each of the lower electrodes LE1, LE2 and LE3 overlaps the stem layer 64, and the other part (second end portion) does not overlap the stem layer 64. Here, the expression "the end portion of each of the lower electrodes LE1, LE2 and LE3 overlaps the lower portion 61" means that these end portions are located under the lower portion 61.

Specifically, the end portions E1b and E1c of the lower electrode LE1 overlaps the lower portion 61, and neither the end portion E1a nor the end portion E1d overlaps the lower portion 61. The end portions E2b, E2c and E2d of the lower electrode LE2 overlap the lower portion 61, and the end portion E2a does not overlap the lower portion 61. The end portions E3b and E3c of the lower electrode LE3 overlap the lower portion 61, and neither the end portion E3a nor the end portion E3d overlaps the lower portion 61.

For example, when the lower electrodes LE1 and LE2 and the lower portion 61 between them are particularly looked at, one of the end portions of the lower electrodes LE1 and LE2 overlaps this lower portion 61, and the other one does not overlap this lower portion 61. This relationship in which the lower portion 61 overlaps the end portion of one of adjacent lower electrodes and does not overlap the end portion of the other one is established in a large part of the lower portion 61. However, the part 61X located between pixel apertures AP2 and AP3 in the lower portion 61 overlaps both the end portion E2d of the lower electrode LE2 and the end portion E3c of the lower electrode LE3. For example, contact holes formed in an organic insulating layer 12 for connecting the lower electrodes LE2 and LE3 to the respective pixel circuits 1 of a circuit layer 11 are provided under the part 61X.

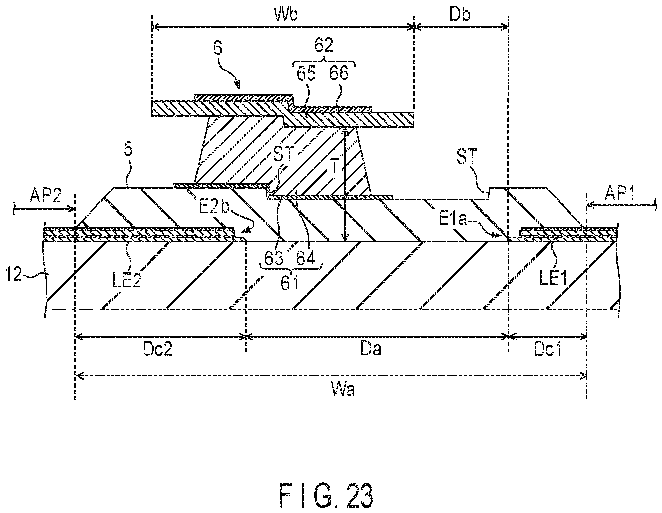

FIG. 23 is a schematic cross-sectional view of a display device DSP along the XXIII-XXIII line of FIG. 22. In this figure, in a manner similar to that of FIG. 5, the organic insulating layer 12, the rib layer 5, the partition 6 and the lower electrodes LE1 and LE2 are shown, and the other elements are omitted.

A stepped portion ST generated on the upper surface of the rib layer 5 by an end portion located under the partition 6, such as the end portion E2b, is covered with a bottom layer 63 and the stem layer 64. To the contrary, a stepped portion ST generated by an end portion which is not located under the partition 6, such as the end portion E1a, is not covered with the bottom layer 63 or the stem layer 64.

The rib layer 5 has width Wa. The partition 6 has width Wb which is less than width Wa (Wa > Wb). Width Wa corresponds to the distance between the pixel apertures AP1 and AP2. Width Wb corresponds to the width of an upper portion 62, more specifically, the width of a first top layer 65. Distance Da between the metal layers ML of the lower electrodes LE1 and LE2 is less than width Wa (Da < Wa). Distance Da is, for example, equal to width Wb.

The end portion E1a of the lower electrode LE1 and the upper portion 62 are spaced apart from each other as seen in plan view. Distance Db between the end portion E1a and the upper portion 62 in plan view is, for example, greater than or equal to 1/2 of total thickness T of the rib layer 5 and the lower portion 61 (the bottom layer 63 and the stem layer 64). More specifically, distance Db corresponds to the distance between the end portion of the metal layer ML in the end portion E1a and the first top layer 65 in plan view.

In this embodiment, distance Dc1 between the end portion E1a and the pixel aperture AP1 in plan view is less than distance Dc2 between the end portion E2b and the pixel aperture AP2 in plan view (Dc1 < Dc2). More specifically, distance Dc1 corresponds to the distance between the end portion of the metal layer ML in the end portion E1a and the pixel aperture AP1 in plan view. Distance Dc2 corresponds to, more specifically, the distance between the end portion of the metal layer ML in the end portion E2b and the pixel aperture AP2 in plan view.

The structure shown in FIG. 23 can be also applied to the structure of the vicinity of the adjacent lower electrodes LE1 and LE3, the structure of the vicinity of the adjacent lower electrodes LE2 and LE3 and the structure of the vicinity of the adjacent two lower electrodes LE1.

Even in the configuration of this embodiment in which a part of each of the lower electrodes LE1, LE2 and LE3 overlaps the lower portion 61, and the other portion does not overlap the lower portion 61, the effect of blocking the moisture path caused by a crack of the rib layer 5 using the metal layer ML can be obtained in a manner similar to that of the first embodiment.

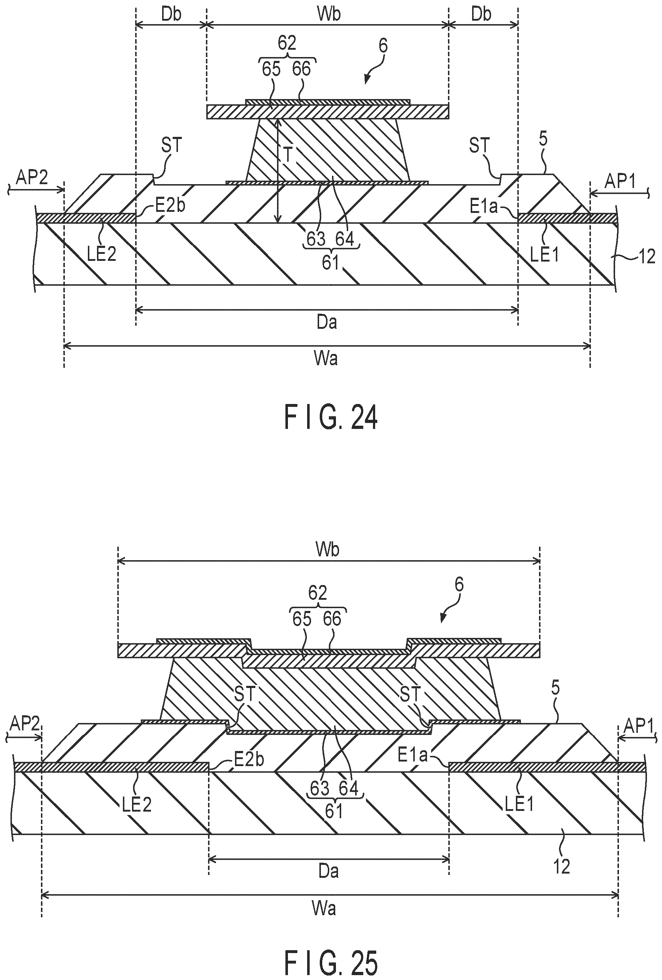

FIG. 24 and FIG. 25 are schematic cross-sectional views of the configurations of comparative examples. These figures focus attention on the end portions E1a and E2b of the lower electrodes LE1 and LE2, the rib layer 5 and the partition 6 in a manner similar to that of FIG. 23.

In FIG. 24, neither the end portion E1a of the lower electrode LE1 nor the end portion E2b of the lower electrode LE2 is located under the partition 6. By this configuration, stepped portions ST caused by these end portions E1a and E2b are exposed from the lower portion 61.

When the partition 6 is formed, the layers to be processed into the bottom layer 63, the stem layer 64, the first top layer 65 and a second top layer 66 are formed in the entire display area DA. These layers could be deformed based on the stepped portions ST. If the stepped portions ST are close to the lower portion 61, the end portions of the upper portion 62 (the first top layer 65 and the second top layer 66) protruding from the lower portion 61 could include a portion which is deformed by the effect of the stepped portions ST. Specifically, there is a possibility that the end portions of the upper portion 62 warp to the upper side.

The layers constituting the stacked films FL1, FL2 and FL3 are formed in the entire display area DA by vapor deposition. At the time of the vapor deposition, these layers are divided by the partition 6 having an overhang shape. If the end portions of the upper portion 62 warp to the upper side, for example, there is a possibility that the organic layers OR1, OR2 and OR3 are attached to the wide range of the lower portion 61, thereby blocking the contact between the upper electrodes UE1, UE2 and UE3 which are formed later and the lower portion 61.

Therefore, in the configuration of FIG. 24, the end portions E1a and E2b of the lower electrodes LE1 and LE2 need to be sufficiently spaced apart from the partition 6. For example, when distance Db between the upper portion 62 and each of the end portions E1a and E2b in plan view is greater than or equal to 1/2 of total thickness T of the rib layer 5 and the lower portion 61 (Db ≥ T/2) as described above, the shape defect of the end portions of the upper portion 62 can be prevented.

It should be noted that, in the configuration of FIG. 24, distance Db should be assured on the both sides of the partition 6. Thus, width Wa of the rib layer 5 is also increased. When width Wa of the rib layer 5 is increased, the pixel apertures AP1, AP2 and AP3 become small in accordance with the increase in width Wa, and thus, the aperture ratios of subpixels SP1, SP2 and SP3 are decreased.

In FIG. 25, both the end portion E1a of the lower electrode LE1 and the end portion E2b of the lower electrode LE2 are located under the lower portion 61. By this configuration, both of the stepped portions ST caused by the end portions E1a and E2b are covered with the lower portion 61. In this case, the shape defect of the end portions of the upper portion 62 caused by the stepped portions ST can be prevented.

However, it is difficult to make distance Da between the lower electrodes LE1, LE2 and LE3 sufficiently less because of the restriction for processing. Therefore, width Wb of the partition 6 needs to be increased to some extent in the configuration of FIG. 25.

In addition, in the vicinity of the partition 6, the evaporation materials emitted from evaporation sources are blocked by the upper portion 62. Thus, the thicknesses of the stacked films FL1, FL2 and FL3 are decreased. Therefore, to form the stacked films FL1, FL2 and FL3 so as to have satisfactory thicknesses in the pixel apertures AP1, AP2 and AP3, the partition 6 needs to be spaced apart from the pixel apertures AP1, AP2 and AP3 to some extent. In consideration of this margin, width Wa of the rib layer 5 in the example of FIG. 25 needs to be equivalent to that of FIG. 24.

With respect to these comparative examples, the configuration of the embodiment shown in FIG. 23 can decrease width Wa of the rib layer 5 even while preventing the shape defect of the upper portion 62 and increase the aperture ratios of subpixels SP1, SP2 and SP3. In this manner, the yield of the display device DSP can be improved, and the display quality can be also improved.

Specifically, in the configuration of FIG. 23, the stepped portion ST caused by the end portion E2b of the lower electrode LE2 is covered with the lower portion 61. Thus, the shape defect caused to the upper portion 62 by the stepped portion ST is prevented. In addition, the shape defect caused to the upper portion 62 by the stepped portion ST generated by the end portion E1a of the lower electrode LE1 can be prevented by making distance Db greater than or equal to 1/2 of total thickness T.

Further, since distance Db is assured in the configuration of FIG. 23, even if distance Dc1 between the end portion E1a and the pixel aperture AP1 is made less, the stacked film FL2 having a satisfactory thickness can be formed in the pixel aperture AP2. By this configuration, width Wa of the rib layer 5 can be reduced compared to the comparative examples of FIG. 24 and FIG. 25.

Here, this specification explains the effects obtained from the embodiment while focusing attention on the structure of the vicinity of the end portions of the adjacent lower electrodes LE1 and LE2 as shown in FIG. 23, FIG. 24 and FIG. 25. However, similar effects can be obtained based on the structure of the vicinity of the adjacent lower electrodes LE1 and LE3, the structure of the vicinity of the end portions of the adjacent lower electrodes LE2 and LE3 and the structure of the vicinity of the end portions of the adjacent two lower electrodes LE1.

The locational relationships of the end portions of the lower electrodes LE1, LE2 and LE3 and the lower portion 61 are not limited to the example shown in FIG. 22. Various other forms may be applied the locational relationships of the end portions of the lower electrodes LE1, LE2 and LE3 and the lower portion 61.

All of the display devices and manufacturing methods thereof that can be implemented by a person of ordinary skill in the art through arbitrary design changes to the display device and manufacturing method thereof disclosed above as each embodiment of the present invention come within the scope of the present invention as long as they are in keeping with the spirit of the present invention.

Various modification examples which may be conceived by a person of ordinary skill in the art in the scope of the idea of the present invention will also fall within the scope of the invention. For example, even if a person of ordinary skill in the art arbitrarily modifies the above embodiments by adding or deleting a structural element or changing the design of a structural element, or by adding or omitting a step or changing the condition of a step, all of the modifications fall within the scope of the present invention as long as they are in keeping with the spirit of the invention.

Further, other effects which may be obtained from the above embodiments and are self-explanatory from the descriptions of the specification or can be arbitrarily conceived by a person of ordinary skill in the art are considered as the effects of the present invention as a matter of course.

## Claims

1. A display device (DSP) **characterized by** comprising:
an insulating layer (12);
a lower electrode (LE1, LE2, LE3) provided above the insulating layer (12);
a rib layer (5) which has a pixel aperture (AP1, AP2, AP3) overlapping the lower electrode (LE1, LE2, LE3) ;
a partition (6) which includes a lower portion (61) provided above the rib layer (5) and an upper portion (62) having an end portion protruding from a side surface of the lower portion (61);
an organic layer (OR1, OR2, OR3) which covers the lower electrode (LE1, LE2, LE3) through the pixel aperture (AP1, AP2, AP3) and emits light based on application of voltage; and
an upper electrode (UE1, UE2, UE3) which covers the organic layer (OR1, OR2, OR3), wherein
the lower electrode (LE1, LE2, LE3) includes:
a reflective layer (RL) which reflects light emitted from the organic layer (OR1, OR2, OR3); and
a metal layer (ML) provided between the reflective layer (RL) and the insulating layer (12) and having an end portion which protrudes from the reflective layer (RL).

2. The display device (DSP) of claim 1, wherein
the rib layer (5) is formed of an inorganic insulating material.

3. The display device (DSP) of claim 1, wherein
the metal layer (ML) is thinner than the reflective layer (RL).

4. The display device (DSP) of claim 1, wherein
the reflective layer (RL) is formed of silver, and
the metal layer (ML) is formed of titanium, titanium nitride, tungsten or a molybdenum-tungsten alloy.

5. The display device (DSP) of claim 1, further comprising a first coating layer (V1) which is formed of a transparent conductive oxide and covers a lower surface of the reflective layer (RL) facing the metal layer (ML).

6. The display device (DSP) of claim 5, wherein
the first coating layer (V1) is thinner than the metal layer (ML).

7. The display device (DSP) of claim 5, wherein
an end portion of the first coating layer (V1) is retracted relative to an end portion of the reflective layer (RL).

8. The display device (DSP) of claim 5, further comprising a second coating layer (V2) which is formed of a transparent conductive oxide and covers an upper surface of the reflective layer (RL).

9. The display device (DSP) of claim 8, wherein
the second coating layer (V2) is thicker than the first coating layer (V1) and thinner than the reflective layer (RL).

10. The display device (DSP) of claim 8, wherein
an end portion of the second coating layer (V2) is retracted relative to an end portion of the reflective layer (RL).

11. The display device (DSP) of claim 1, wherein
a protrusion length of the metal layer (ML) from the reflective layer (RL) is greater than or equal to a thickness of the reflective layer (RL).

12. The display device (DSP) of claim 1, wherein
the end portion of the metal layer (ML) has a tapered shape in which a thickness gradually decreases.

13. The display device (DSP) of claim 1, wherein
the end portion of the metal layer (ML) overlaps the lower portion (61) as a whole in plan view.

14. The display device (DSP) of claim 1, wherein
the metal layer (ML) has:
a first end portion (E2b) which overlaps the lower portion (61) in plan view; and
a second end portion (E1a) which does not overlap the lower portion (61) in plan view.

15. The display device (DSP) of claim 14, wherein
a distance (Db) between the second end portion (Ea1) and the upper portion (62) in plan view is greater than or equal to 1/2 of a total thickness (T) of the rib layer (5) and the lower portion (61).

16. A manufacturing method of a display device (DSP), **characterized by** including:
forming an insulating layer (12);
forming, above the insulating layer (12), a lower electrode (LE1, LE2, LE3) which includes a reflective layer (RL) reflecting light and a metal layer (ML) provided between the reflective layer (RL) and the insulating layer (12) and having an end portion which protrudes from the reflective layer (RL);
forming a rib layer (5) which covers the lower electrode (LE1, LE2, LE3);
forming a partition (6) which includes a lower portion (61) provided above the rib layer (5) and an upper portion (62) having an end portion which protrudes from a side surface of the lower portion (61) ;
forming a pixel aperture (AP1, AP2, AP3) in the rib layer (5) before forming the partition (6) or after forming the partition (6);
forming an organic layer (OR1, OR2, OR3) which covers the lower electrode (LE1, LE2, LE3) through the pixel aperture (AP2, AP2, AP3) and emits light based on application of voltage; and
forming an upper electrode (UE1, UE2, UE3) which covers the organic layer (OR1, OR2, OR3).

17. The manufacturing method of claim 16, wherein
the forming the lower electrode (LE1, LE2, LE3) includes:
forming a first layer (MLa) using a material of the metal layer (ML) on the insulating layer (12);
forming a second layer (RLa) using a material of the reflective layer (RL) above the first layer (MLa) ;
providing a resist (R0) on the second layer (RLa);
forming the reflective layer (RL) by removing a portion of the second layer (RLa) exposed from the resist (R0) by first etching; and
forming the metal layer (ML) by removing a portion of the first layer (MLa) exposed from the resist (R0) by second etching.

18. The manufacturing method of claim 17, wherein
a width of the second layer (RLa) is reduced compared to the a width of the resist (R0) by the first etching.

19. The manufacturing method of claim 17, wherein
the first etching is wet etching, and
the second etching is dry etching.

20. The manufacturing method of claim 19, wherein
the first metal layer (MLa) is formed of a metal material in which an etching rate for an etchant of the first etching is slower than the second layer (RLa).
